(19) Europäisches Patentamt
European Patent Office
Office européen des brevets

(11) **EP 2 131 373 B1**

(12) **EUROPÄISCHE PATENTSCHRIFT**

(45) Veröffentlichungstag und Bekanntmachung des Hinweises auf die Patenterteilung:
**02.11.2016   Patentblatt 2016/44**

(51) Int Cl.:
*H01F 1/37* (2006.01)     *H01F 41/02* (2006.01)
*C04B 35/63* (2006.01)     *C04B 35/26* (2006.01)

(21) Anmeldenummer: **09160189.8**

(22) Anmeldetag: **13.05.2009**

(54) **Weichmagnetischer Werkstoff und Verfahren zur Herstellung von Gegenständen aus diesem weichmagnetischen Werkstoff**

Soft magnetic material and method for producing objects from this soft magnetic material

Matériau magnétique doux et procédé de fabrication d'objets à partir de ce matériau magnétique doux

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **05.06.2008   DE 102008026887**
**05.06.2008   DE 102008026888**
**25.09.2008   DE 102008048839**

(43) Veröffentlichungstag der Anmeldung:
**09.12.2009   Patentblatt 2009/50**

(73) Patentinhaber: **TRIDELTA Weichferrite GmbH 07629 Hermsdorf (DE)**

(72) Erfinder:
- **Dr. Gablenz, Silvio**
  **06110 Halle (DE)**
- **Kloucek, Marko**
  **07570 Niederpöllnitz (DE)**

(74) Vertreter: **Henkel, Breuer & Partner Patentanwälte Maximiliansplatz 21 80333 München (DE)**

(56) Entgegenhaltungen:
**EP-A- 0 921 534        WO-A-2006/122195**
**JP-A- 2005 145 803**

**Beschreibung**

Die Erfindung betrifft einen weichmagnetischen Werkstoff zur Herstellung beispielsweise von Abschirmungsmaterialien gegen elektromagnetische Wellen, Gehäusen für elektronische und elektrische Geräte und zum Einsatz in elektronischen Bauteilen, wie etwa Drosselspulen und Transformatoren.

Materialien, um elektromagnetische Felder abzuschirmen, werden in der industriellen Anwendung zunehmend wichtig. Elektromagnetische Wellen können etwa beim Einsatz hochgetakteter elektronischer Bauteile zu Störungen benachbarter Bauteile führen. Darüber hinaus gibt es ein allgemeines Bestreben die elektromagnetische Strahlung zu verringern.

In den letzten Jahren haben sich insbesondere Kompositwerkstoffe für diese Zwecke bewährt. Derartige Kompositwerkstoffe weisen regelmäßig ein magnetisch aktives Material, meistens ein Ferrit, in einer Kunststoffmatrix auf. So zeigt beispielsweise die deutsche Patentanmeldung DE 102 22 459 A1 einen derartigen Kompositwerkstoff mit einem modifizierten Ferritpulver, elektrisch leitfähigen Nichtmetallpartikeln und einem magnetischen Bindemittel in einer Polymermatrix. Ein bevorzugtes Ferrit in diesem Zusammenhang ist Mangan-Zink-Ferrit.

Ähnliche Materialien sind inzwischen auch käuflich erhältlich und werden beispielsweise von der Firma EPCOS AG unter dem Namen C350 oder C351 ("Ferrites and Accessoires"; EPCOS AG; Edition 09/2006), von der Firma Vogt (Produktkatalog "Inductive Component and Modules"; Vogt Elektronic Components GmbH; Edition 2005) und von der Firma Kerafol GmbH (Sicherheitsdatenblatt "Keratherm Typ 86/XX"; 6 2000) vertrieben.

Die bekannten Materialien weisen jedoch eine Reihe von Nachteilen auf. Ein wesentlicher Aspekt ist, dass die Dichte der bekannten Materialien aufgrund eines sehr hohen Kunststoffanteils regelmäßig unter 2,5 g/cm$^3$ liegt. Insoweit ist für eine effektive Abschirmung ein beachtliches Volumen nötig.

Ein weiterer Nachteil besteht darin, dass diese bekannten Materialien mit Spritzgusstechnik verarbeitet werden müssen, und meist eine sehr geringe mechanische Festigkeit haben. So liegen die Zugfestigkeiten regelmäßig unter 2,5 N/mm$^2$.

Bei den bekannten Kompositwerkstoffen dieser Art werden vorwiegend Ethylen/Vinyl-Copolymerisat bzw. Polyamid für die Kunststoffmatrix verwendet. Dies begrenzt die Einsatztemperatur auf Bereiche deutlich unter 200°C, was dazu führt, dass die Materialien nicht für alle Zwecke eingesetzt werden können.

Auch hinsichtlich der magnetischen Eigenschaften waren die Materialien noch nicht völlig zufriedenstellend. Zwar war es möglich, mit diesen Materialien Anfangspermeabilitätswerte $\mu_i$ von 7 bis 20 zu verwirklichen, aber weder war es möglich, Werte unter diesem Bereich zu erreichen, noch eine gezielte Einstellung des Wertes im Voraus festzulegen. Auch hinsichtlich der erreichbaren Sättigungsmagnetisierung bzw. des Koerzitivfeldes $H_c$ waren die Materialien noch unbefriedigend.

Ein weiterer Kompositwerkstoff und ein Herstellungsverfahren für diesen ist in der Patentanmeldung EP 1 564 767 A2 gezeigt. Diese Patentanmeldung schlägt vor, ein magnetisches Pulvermaterial zu sieben, um zwei Fraktionen zu bilden. Die eine Fraktion, die am Sieb hängen bleibt, wird anschließend mit einem isolierenden und bindenden dielektrischen Material beschichtet. Die feine Fraktion, die durch das Sieb gelangt, wird mit dem beschichteten magnetischen Pulver anschließend wieder vermischt und das Gemisch bei einer Temperatur unterhalb der Glastemperatur verpresst. Das komprimierte Produkt wird erwärmt und mit einem thermoplastischen Harz verbacken. Die magnetische Permeabilität $\mu_i$ stellt sich bei Werten um 350 ein. Die Entgegenhaltung geht von Teilchengrößen im Bereich von 0,1 mm bis 0,125 mm aus.

Schließlich zeigt die europäische Patentanmeldung EP 1 669 408 einen Kompositwerkstoff und ein Verarbeitungs- bzw. Herstellungsverfahren für dieses Material. Diese Druckschrift zeigt, dass bei geeigneter Mischung von Wasser, Kunststoff und dem magnetischen Pulver, beispielsweise Mangan-Zink-Ferrit, eine Verarbeitung mit Sprühtrocknung möglich ist. Die in den Beispielen gezeigten Mischungsverhältnisse zwischen den magnetischen Teilchen und dem Kunststoff führen zu einer Dichte, die unter 3 g/cm$^3$ liegt. Die eingesetzten Ferrite hatten Teilchengrößen im Bereich von 1,6 bis 8,5 $\mu$m. Bei dieser Patentanmeldung wird als Kunststoffmaterial ein Harz, mit ungesättigten Vinyleinheiten verwendet. Dies führt dazu, dass nach dem Sprühtrocknen harte und relativ spröde Teilchen erhalten werden. Diese können dann unverarbeitet als Pulver, gelöst als Anstrich oder mittels Gusstechnik weiter verwendet werden. Aufgrund der Sprödigkeit der Teilchen ist jedoch ein Trockenpressen ausgeschlossen.

Weiter zeigt EP 1 790 460 A1 eine isolierende Beschichtung eines elektrischen Bauteils mit einem duroplastischen Polymer und einem Füllmaterial im Nanobereich.

DE 10 790 460 A1 zeigt einen magnetorheologischen Elastomer, dessen mechanische Eigenschaften mit dem angelegten Magnetfeld variieren, mit magnetisierbaren Teichen, die eine bimodale Größenverteilung aufweisen.

US 2007/0102663 A1 zeigt eine magnetische Paste mit multi-modalen magnetischen Bestandteilen.

US 2002/0190236 A1 zeigt ein mittels Sprühtrocknung hergestelltes magnetisches Granulat, das neben einem magnetischen Bestandteil auch Kunststoffbestandteile enthält. Das Granulat wird bei 1300°C gesintert, wobei der Kunststoff vollständig verdampft. Ein ähnliches Verfahren ist in EP 1 818 954 A1 gezeigt.

Die Druckschrift WO2006/122195 offenbart einen weichmagnetischen Werkstoff in Form einer Paste in einer flüßigen organischen Harzkomponente und mit weichmagnetischen Teilchen in verschiedenen Größen.

Die Druckschrift JP2005-145803 offenbart ein Verfahren zum Herstellen eines weichmagnetischen Materials, bei dem ZnO Pulver und MnO Pulver gemischt, und nach einer Sprühtrocknung bei 1330 °C kalziniert werden, wodurch sich ein weichmagnetischer Festkörper, beispielsweise ein Ringkern, bildet.

Schließlich zeigt die Druckschrift EP-A-921534 einen weichmagnetischen Werkstoff mit weichmagnetischen Teilchen verschiedener Größe, von denen die kleinste Größe im Bereich von 125$\mu$m liegt. Diese Teilchen werden zusammen mit einem Kunststoffharz verarbeitet.

Aufgabe der Erfindung ist es, einen neuen Werkstoff bereitzustellen, der sowohl hinsichtlich seiner mechanischen als auch magnetischen Eigenschaften verbessert ist, und der sich leicht und sicher verarbeiten lässt.

Eine weitere Aufgabe der Erfindung ist es, ein Verfahren zur Herstellung von Gegenständen aus einem weichmagnetischen Kompositwerkstoff bereitzustellen, das einfach in der Handhabung und kostengünstig ist und Gegenstände mit verbesserten magnetischen und mechanischen Eigenschaften liefert.

Gelöst werden diese Aufgaben durch einen Werkstoff nach Anspruch 1 und durch ein Verfahren nach Anspruch 11 oder 16. Die abhängigen Ansprüche beziehen sich auf weitere vorteilhafte Aspekte der Erfindung.

Außerdem betrifft die Erfindung einen weichmagnetischen Werkstoff mit einer Dichte von 2,9 g/cm$^3$ oder mehr, bevorzugt mehr als 3,1 g/cm$^3$ und insbesondere bevorzugt mehr als 4 g/cm$^3$.

Die Erfindung betrifft auch einen weichmagnetischen Werkstoff mit einer Zugfestigkeit von mehr als 3 N/mm$^2$, bevorzugt mehr als 9 N/mm$^2$ und insbesondere bevorzugt von 14 N/mm$^2$.

Letztlich betrifft die Erfindung auch einen weichmagnetischen Werkstoff mit einer Anfangspermeabilität $\mu_i$ von 5 bis 200, einer Sättigungsmagnetisierung von 100 mT oder mehr und einem Wert für den relativen Verlustfaktor von tan d/$\mu_i$ kleiner 3000 * 10$^{-6}$, bevorzugt kleiner 1700 x 10$^{-6}$, noch besser kleiner 400 x 10$^{-6}$.

Gemäß einem ersten Aspekt umfasst der weichmagnetische Werkstoff eine Mikro-Fraktion aus Teilchen eines weichmagnetischen Materials mit einer Teilchengröße im Bereich von 1 bis 350 $\mu$m, und eine Nano-Fraktion aus Teilchen eines weichmagnetischen Materials mit einer Teilchengröße im Bereich von 10 bis 200 nm, wobei der Anteil der Nano-Fraktion an der Gesamtmasse von Mikro-Fraktion und Nano-Fraktion 5 bis 70 Masse-% beträgt.

Vorzugsweise ist das weichmagnetische Material ein Ferrit, insbesondere Mangan-Zink-Ferrit, wobei die Teilchen der Mikro-Fraktion und der Nano-Fraktion optional aus dem gleichen Material bestehen.

Vorzugsweise ist der weichmagnetische Werkstoff ein Mangan-Zink-Ferrit der Formel Mn$_a$Zn$_b$Fe$_{2+c}$O$_{4+d}$, wobei die Größe a, b, c und d in folgendem Bereich liegen:

$$0,05 < a < 0,8;$$

$$0,05 < b < 0,6;$$

$$0,02 < c < 0,9;$$

$$-0,05 < d < 0,05,$$

wobei a + b + c = 1 ist.

Vorzugsweise ist der Anteil der Nano-Fraktion an der Gesamtmasse von Mikro-Funktion und Nano-Fraktion mindestens 10 Masse-%, weiter bevorzugt mindestens 30 Masse-% und ferner weniger als 50 Masse-%, weiter bevorzugt weniger als 40 Masse-% der Nano-Fraktion.

Vorzugsweise hat der weichmagnetische Werkstoff eine Dichte von 2,9 g/cm$^3$ oder mehr, bevorzugt mehr als 3,1 g/cm$^3$ und insbesondere bevorzugt 4 g/cm$^3$ oder mehr, nachdem der Werkstoff einem Sprühtrocknungsschritt, einem Trockenpressschritt und einem Anlassschritt bzw. einem Anschmelzschritt unterzogen wurde.

Vorzugsweise hat der weichmagnetische Werkstoff eine Zugfestigkeit von mehr als 3 N/mm$^2$, bevorzugt mehr als 9 N/mm$^2$ und insbesondere bevorzugt mehr als 14 N/mm$^2$, nachdem der Werkstoff einem Sprühtrocknungsschritt, einem Trockenpressschritt und einem Anlassschritt bzw. einem Anschmelzschritt unterzogen wurde.

Vorzugsweise hat der weichmagnetische Werkstoff eine Anfangspermeabilität $\mu_i$ bei 5 bis 200, eine Sättigungsmagnetisierung bei 100 mT oder mehr und der Wert für tan $\delta/\mu_i$ ist kleiner 3000 x 10$^{-6}$, bevorzugt kleiner 1700 x 10$^{-6}$, noch bevorzugter kleiner 400 x 10$^{-6}$, nachdem der Kompositwerkstoff einem Sprühtrocknungsschritt, einem Trockenpressschritt und einem Anlassschritt bzw. einem Anschmelzschritt unterzogen wurde.

Vorzugsweise umfasst der weichmagnetische Werkstoff einen Kunststoffbinder, insbesondere Polyethylentetrafluorid (PZFE) oder Polyetheretherketon (PEEK).

Vorzugsweise ist der Anteil des Binders, bezogen auf die Gesamtmasse von Mikro-Fraktion und Nano-Fraktion, im Bereich von 5 bis 20 Masse-%, bevorzugt bei 8 bis 12 Masse-%.

Das erfindungsgemäße Verfahren zur Herstellung eines Gegenstandes aus einem weichmagnetischen Kompositwerkstoff umfasst: das Bereitstellen eines Schlickers mit einem teilchenförmigen weichmagnetischen Material, einem teilchenförmigen Kunststoffbinder, einem Sprühhilfsmittel und einem Schlickermedium, Sprühtrocknen des Schlickers, Trockenpressen des durch die Sprühtrocknung erhaltenen Granulates zusammen mit einem Presshilfsmittel, Erwärmen des gepressten Gegenstands auf eine Temperatur oberhalb des Schmelzpunktes des Kunststoffbinders.

Im Folgenden wird die Erfindung anhand bevorzugter Beispiele und der beiliegenden Figuren beschrieben.

Fig. 1        zeigt schematisch einen Schnitt durch einen Kompositwerkstoff des Stands der Technik;

Fig. 2        zeigt die selbe Ansicht für einen erfindungsgemäßen weichmagnetischen Kompositwerkstoff;

Fig. 3        zeigt ein Verfahrensdiagramm für die Verarbeitung und Herstellung des erfindungsgemäßen weichmagnetischen Kompositwerkstoffs;

Fig. 4 und 5    zeigen Elektronen-Mikroskopaufnahmen von Teilen des erfindungsgemäßen weichmagnetischen Kompositwerkstoffs;

Fig. 6        zeigt eine Elektronen-Mikroskopaufnahme des Gemischs, und

Fig. 7        zeigt eine Elektronen-Mikroskopaufnahme eines Schliffs des Werkstoffs nach Beispiel 4 ohne Binder.

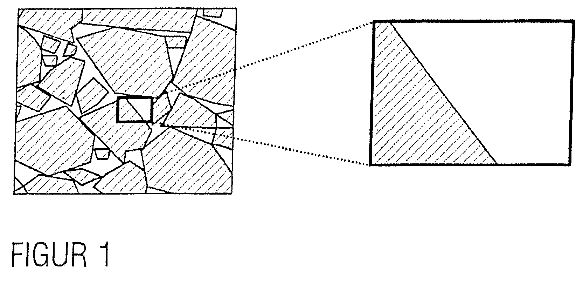

In Fig. 1 ist ein bekannter Kompositwerkstoff gezeigt. In einer Kunststoffmatrix sind magnetisch aktive Teilchen, vorzugsweise Mangan-Zink-Ferrit-Teilchen, aufgenommen. Diese Teilchen werden in üblicher Weise durch Zermahlen eines größeren gesinterten Mangan-Zink-Ferrit-Blocks oder -Kerns erhalten. Der Durchmesser der Teilchen bewegt sich zwischen einigen wenigen und 100 $\mu$m.

Das so zermahlene bzw. granulierte Material wird zusammen mit dem Kunststoffbindemittel im Spritzgussverfahren verarbeitet und als Folie bereitgestellt.

Aufgrund der Sprödigkeit der Mangan-Zink-Ferrit-Kristalle hat das Material allerdings eine schlechte Kompressibilität, und es verbleiben große Poren, was zu einer sehr geringen Enddichte führt. Die zwischen den einzelnen Mangan-Zink-Ferrit-Teilchen verbleibenden Hohlräume, die entweder mit Luft oder mit der Kunststoffmatrix gefüllt sind, beeinflussen darüber hinaus negativ die magnetischen Eigenschaften des Gesamtmaterials.

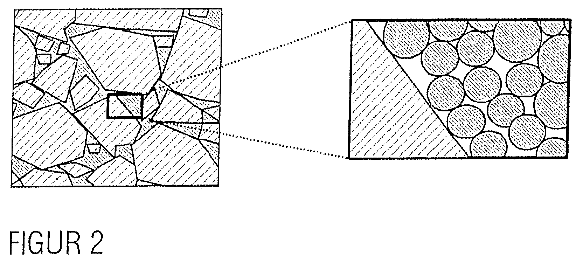

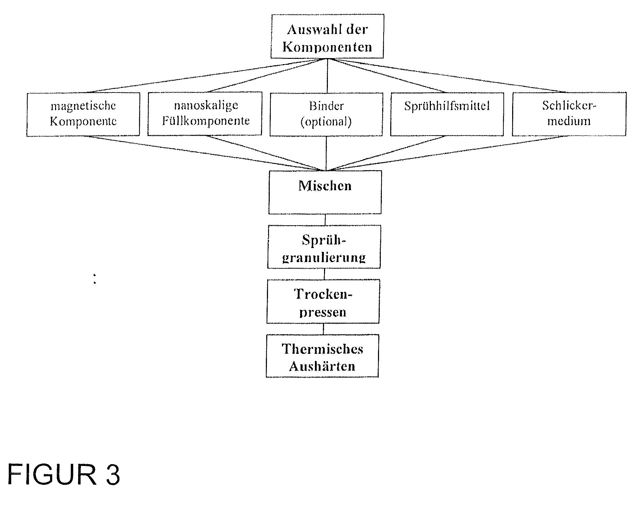

Fig. 2 zeigt eine zur Fig. 1 ähnliche Darstellung bezogen auf den erfindungsgemäßen weichmagnetischen Werkstoff. Das Verfahren zur Herstellung dieses weichmagnetischen Werkstoffs ist in Fig. 3 skizziert.

Ein wesentlicher Unterschied des erfindungsgemäßen Werkstoffs gegenüber dem Stand der Technik besteht darin, dass neben den magnetisch aktiven Teilchen mit einem Teilchengrößenspektrum von 1 bis 350 $\mu$m, im Folgenden als Mikro-Fraktion bezeichnet, noch zusätzlich eine Nano-Fraktion des gleichen oder eines ähnlichen Materials vorhanden ist. Die mittlere Teilchengröße dieser zweiten Nano-Fraktion liegt im Bereich von 10 bis 200 nm, vorzugsweise im Bereich im Bereich zwischen 30 und 60 nm, weiter bevorzug bei 50 nm.

Da die Teilchen der Nano-Fraktion um etwa drei Größenordnungen kleiner als die Teilchen der Mikro-Fraktion sind, werden die Spalten zwischen Mikro-Teilchen sehr dicht ausgefüllt, so dass insgesamt ein Material mit einer sehr hohen Dichte entsteht.

Im Folgenden wird kurz das Herstellungsverfahren anhand von Fig. 3 beschrieben.

In einem ersten Schritt wird ein Block oder Kern aus einem magnetisch aktiven Material, vorzugsweise einem Ferrit, besonders bevorzugt einem gesinterten Mangan-Zink-Ferrit, bereitgestellt. Die Erfindung ist nicht auf weichmagnetische Materialien beschränkt. Auch hartmagnetische Ferrite können als Ausgangsstoff verwendet werden, was dann zu einem hartmagnetischen Werkstoff führt.

Mangan-Zink-Ferrit ist ein bekannter weichmagnetischer Werkstoff mit der allgemeinen Formel $Mn_aZn_bFe_{2+c}O_{4+d}$, wobei die Größen a, b, c und d in folgendem Bereich nach Wunsch eingestellt werden können,

$$0,05 < a < 0,8;$$

$$0,05 < b < 0,6;$$

$$0,02 < c < 0,9;$$

$$-0,05 < d < 0,05,$$

wobei

$$a + b + c = 1 \text{ ist.}$$

In einem zweiten Schritt wird dieser Kern erst zerkleinert, beispielsweise mit einem Backenbrecher, wobei Teilchen in der Größenordnung von einigen mm, beispielsweise 3 mm, erhalten werden. Diese Teilchen werden dann einem zweiten Zerkleinerungsvorgang, beispielsweise einem Trockenmahlen oder Nassmahlen, unterzogen, wobei Teilchen im Bereich von einigen 10 $\mu$m bis 400 $\mu$m, vorzugsweise im Bereich von 50 $\mu$m erhalten werden. Ein Teil dieser Teilchen wird als Mikro-Fraktion entnommen.

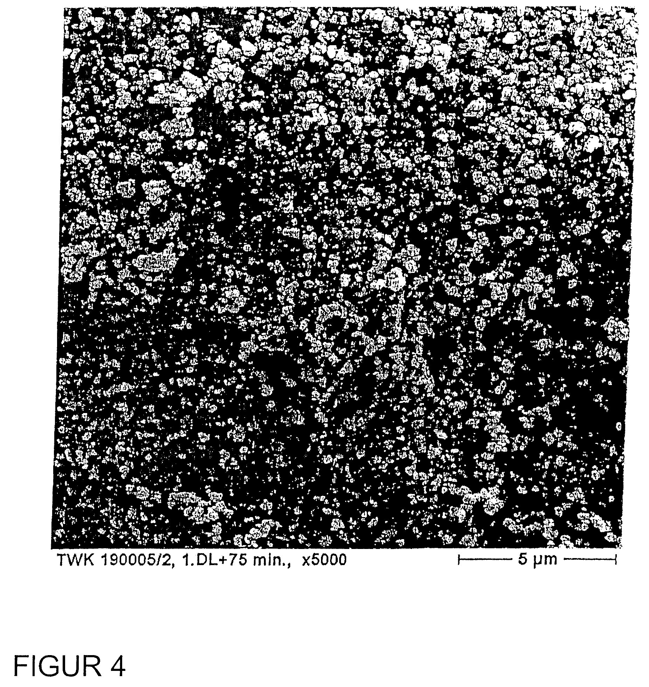

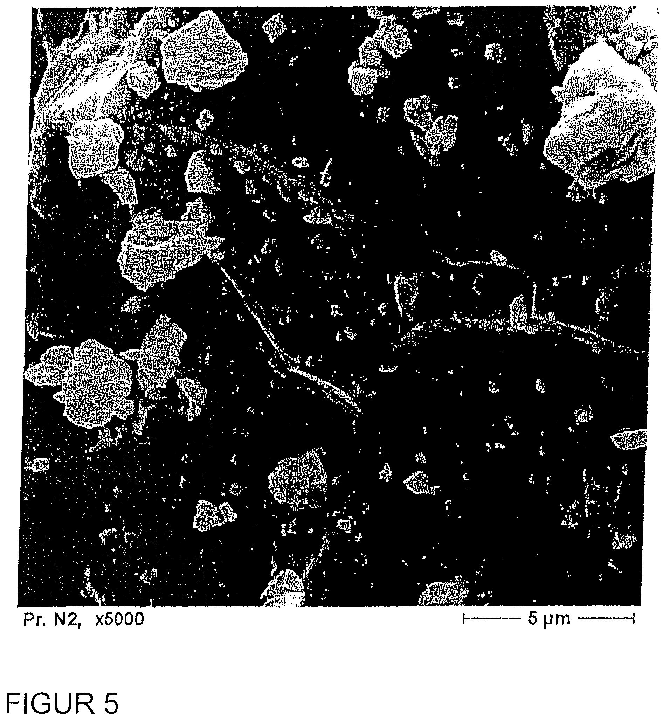

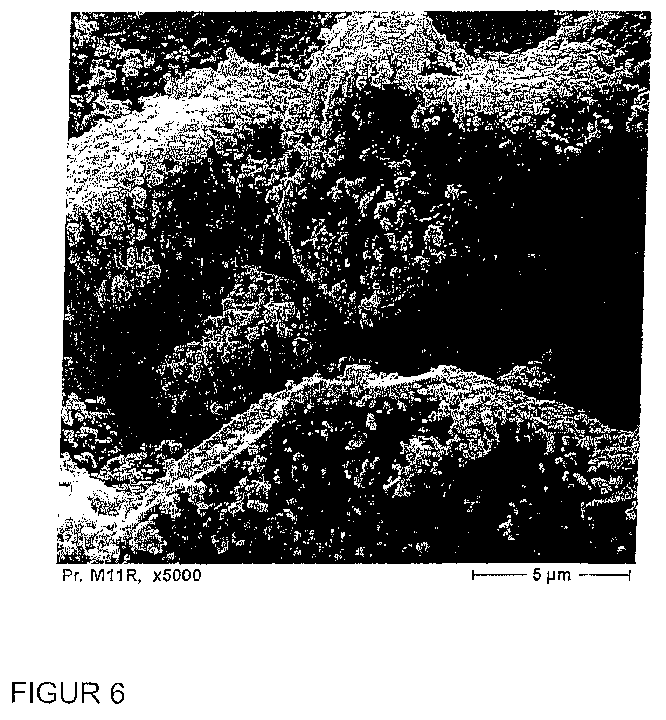

Der verbleibende Teil wird einem weiteren Zerkleinerungsvorgang, beispielsweise einem weiteren Trockenmahlen unterzogen, bis Teilchen in der Größenordnung von 10 $\mu$m erhalten werden. In zwei darauf folgenden Nassmahlschritten werden die Teilchen weiter zerkleinert, bis schließlich Teilchen im Bereich von einigen 10 nm erhalten werden. Elektronen-Mikroskopaufnahmen der Mikro-Fraktion und der Nano-Fraktion sind jeweils in den Fig. 4 bzw. 5 gezeigt. Fig. 6 zeigt eine entsprechende Aufnahme des Gemischs.

Die Teilchen der Nano-Fraktion können auch durch andere bekannte Technologien erhalten werden, z.B. durch eine Fällung aus geeigneter Lösung (etwa Oxalatfällung), durch ein Sol-Gel-Verfahren, durch ein Mikroemulsionsverfahren oder durch eine Polyolsynthese.

Die beiden Fraktionen werden in einem vorgegebenen Verhältnis gemischt. Bevorzugte Mischungsverhältnisse liegen etwa bei einem Anteil von 5 bis 70 Masse-% der Nano-Fraktion bezogen auf die Gesamtmasse aus Mikro-Fraktion und Nano-Fraktion. Weiter bevorzugt ist ein Mischungsverhältnis von mindestens 10 Masse-%, weiter bevorzugt von mindestens 30 Masse-% der Nano-Fraktion bezogen auf die Gesamtmasse aus Mikro-Fraktion und Nano-Fraktion. Weiter bevorzugt ist ein Mischungsverhältnis von höchstens 50 Masse-%, noch weiter bevorzugt von höchstens 40 Masse-% der Nano-Fraktion bezogen auf die Gesamtmasse aus Mikro-Fraktion und Nano-Fraktion.

Wenn der Anteil der Nano-Fraktion zu klein wird, verbleiben zu viele Leerräume zwischen den Teilchen der Mikro-Fraktion, was zu einer Verringerung der Gesamtdichte führt und nachteilig für die Gesamteigenschaften des Werkstoffs ist. Ein zu hoher Anteil der Nano-Fraktion, die hinsichtlich ihrer magnetischen Eigenschaften weniger vorteilhaft ist als die Mikro-Fraktion, beeinträchtigt ebenfalls nachteilhaft die Eigenschaften des Werkstoffs.

Der Mischung der beiden Teilchenfraktionen kann dann noch ein Bindemittel, vorzugsweise ein Polyethylentetrafluorid (PTFE) oder ein Polyetheretherketon (PEEK) hinzugegeben werden.

PTFE ist ein voll-fluoriertes Polymer, das umgangssprachlich auch gelegentlich unter dem Namen Teflon bezeichnet wird. PTFE ist ein thermoplastischer Kunststoff mit einer Dichte von 2,16 g/cm$^3$ und ausgezeichneter chemischer Beständigkeit. Der Schmelzpunkt liegt bei ca. 327°C.

PEEK ist ein hochtemperaturbeständiger thermoplastischer Kunststoff mit einem Schmelzpunkt bei ca. 335°C und mit einer Dichte im Bereich von ca. 1,3 g/cm$^3$.

Andere bekannte Kunststoffbinder können ebenfalls verwendet werden, wobei allerdings der Einsatz von PEEK und PTFE bevorzugt ist, da diese aufgrund ihrer Temperaturstabilität und guten Bindungseigenschaften sich positiv auf die Gesamteigenschaften des Werkstoffs auswirken. Insbesondere in Kombination mit Mangan-Zink-Ferrit, der eine Curietemperatur im Bereich von ca. 120 - 300 °C hat, ermöglichen diese Kunststoffbinder den Einsatz des Werkstoffs fast im gesamten Temperaturbereich. Der Kunststoffbinder wird bezogen auf die Gesamtmasse der Mikro-Fraktion und der Nano-Fraktion in einem Verhältnis von 5 bis 20%, bevorzugt 8 bis 12% und weiter bevorzugt 9% zugefügt.

Der Mischung aus Mikro-Fraktion, Nano-Fraktion und optional Binder wird ein Sprühhilfsmittel, beispielsweise ein Polyvinylalkohol (PVA), beigegeben. Schließlich wird als weitere Komponente ein Schlickermedium zugefügt, dies ist vorzugsweise Wasser. Der Anteil PVA an der Miscxhung liegt bei unter 1%, bevorzugt bei 0,7%.

Diese auch als Schlicker bezeichnete Mischung dieser Komponenten wird mit einem Quirl verrührt, um eine Entmischung zu vermeiden, so dass sich eine Suspension der Mikro-Teilchen, Nano-Teilchen, optional des Kunststoffbinders, des Polyvinylalkohols in Wasser als Schlickermedium bildet. Der Feststoffanteil des Schlickers liegt zwischen 30 und 65 Masse-%, bevorzugt zwischen 40 und 60 Masse-% und besonders bevorzugt bei ca. 55 Masse-%.

Der Schlicker kann einer Sprühgranulierung bzw. Sprühtrocknung unterzogen werden. Sprühgranulierung oder Sprühtrocknung ist ein kontinuierlich oder diskontinuierlich durchgeführtes Verfahren zur Trocknung von Lösungen, Suspensionen oder pastösen Massen.

Mittels einer Düse (durch Flüssigkeitsdruck oder Pressluft bzw. Inertgas betrieben) oder rotierende Zerstäuberscheiben (4000 bis 50000 Umdrehungen/Minute) wird das zu trocknende Gut in einem Heißluftstrom eingebracht, der es in Bruchteilen von Sekunden zu einem feinen Pulver trocknet. Die Heißluft kann in Richtung mit dem Sprühmittel oder gegen den Sprühstrahl strömen.

Die Sprüheinrichtung befindet sich regelmäßig an einem oberen Teil eines Sprühturms, so dass das anfallenden Trockengut durch einen Zyklonenabscheider vom Luftstrom getrennt und entnommen werden kann. Durch das schnelle Überführen in den trockenen Zustand via Sprühgranulierung wird die Verteilung der Teilchen konserviert. Es bildet sich hierbei ein rieselfähiges sphärisches Granulat.

Zur Weiterverarbeitung zum letztendlich herzustellenden Werkstück kann dieses Granulat, ggf. zusammen mit einem Presshilfsmittel, z.B. einem Kunststoffharz, einem Trockenpressprozess unterzogen werden, wobei es verdichtet wird.

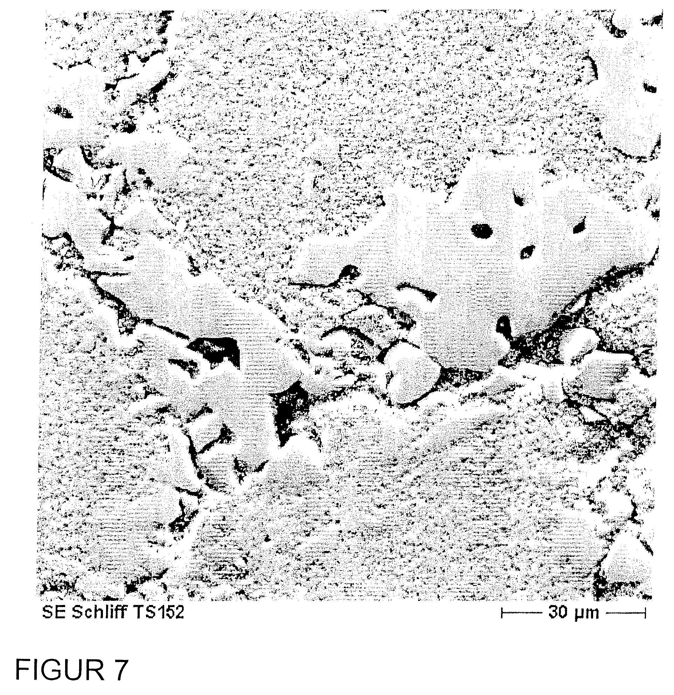

In einem letzten Schritt, wie es in Fig. 3 gezeigt ist, wird das Material noch einer Wärmebehandlung unterzogen. Hierzu wird das Material "angelassen", d. h. der gepresste Körper wird schnell- und kurzzeitig erwärmt, wobei die beim Pressen entstandenen Spannungen abgebaut werden. Bei Verwendung eines Materials, das einen Kunststoffbinder umfasst, wird dieser beim Anlassen auf eine Temperatur oberhalb des Schmelzpunktes, aber unterhalb des Zersetzungs- oder Verdampfungspunktes, des gewählten Binders erwärmt, beispielsweise auf 360 bis 380°C, wobei dann ein Verkleben der keramischen Komponenten durch das Schmelzen und Erstarren des Binders erfolgt. Bei Verwendung eines Materials ohne Binder wird dieses beim Anschmelzen auf deutlich höhere Temperaturen, beispielsweise 1020 °C, erwärmt, wobei unter vermindertem Sauerstoffpartialdruck gearbeitet wird, wodurch die keramischen Komponenten beispielsweise über "Sinterhälse" verfestigt werden. Hierbei werden Temperaturen angesteuert, bei denen die nanoskaligen Teilchen partiell erst Sinterhälse untereinander und in der Peripherie zur Mikro-Fraktion ausbilden. Die Korngrenzen der Mikroteilchen werden hierbei lediglich angelöst, verschmelzen mit der nanoskaligen Matrix und tragen so zur Erhöhung der Dichte und Festigkeit bei, wie dies in Fig. 7 gezeigt ist.

Der auf diese Art hergestellte weichmagnetische Werkstoff hat eine Reihe von vorteilhaften Eigenschaften, die ihn gegenüber dem Stand der Technik auszeichnen. Darüber hinaus ergibt sich aufgrund der Steuerbarkeit verschiedener Einflussparameter leicht die Möglichkeit, spezielle Eigenschaften in einem gewissen Bereich zu optimieren. Beispielsweise ist es möglich, die Anfangspermeabilität $\mu_i$ fast beliebig auf Werte zwischen 5 und 200 einzustellen. Dies geschieht beispielsweise durch die Auswahl des magnetischen Materials, etwa des Mangan-Zink-Ferrits, durch das Mischungsverhältnis der Mikro-Fraktion und der Nano-Fraktion, sowie durch die Größe der Teilchen der Mikro-Fraktion und durch das Hinzufügen bzw. Weglassen des Binders.

Auch die mechanischen Eigenschaften des Materials lassen sich in einem großen Bereich variieren. Beispielsweise lässt sich die Zugfestigkeit durch die Auswahl des Binders, durch den Pressdruck bei dem Trockenpressschritt sowie durch die jeweiligen Teilchengrößen der Mikro- und Nano-Fraktion und deren Mischungsverhältnis beeinflussen. Es lassen sich beachtliche Zugfestigkeiten erreichen, die deutlich über 10 N/mm$^2$, beispielsweise bei 14 N/mm$^2$ liegen können. Zum Vergleich sei angemerkt, dass der gesinterte Mangan-Zink-Ferrit eine Zugfestigkeit von etwa 20 N/mm$^2$ hat. Bekannte Kompositwerkstoffe erreichen Werte von etwa 2 bis 2,5 N/mm$^2$.

Auch die Dichte des Materials, die für die magnetischen Eigenschaften ebenfalls von ausschlaggebender Bedeutung ist, lässt sich in großem Bereich variieren. Das Mischungsverhältnis der Mikro-Fraktion und der Nano-Fraktion ist hierfür von großer Bedeutung. Mit dem erfindungsgemäßen Werkstoff lassen sich Dichten größer als 4 g/cm$^3$ für einen Mangan-Zink-Ferrit erreichen. Im Vergleich hierzu hat ein kompakt-gesinterter Mangan-Zink-Ferrit-Kern eine Dichte von 4,9 g/cm$^3$, bekannte Kompositwerkstoffe erreichen Werte von weniger als 2,9 g/cm$^3$.

Beim Einsatz von Mangan-Zink-Ferrit als Werkstoff, anstelle des noch vielfach verwendeten Nickel-Zink-Ferrits im Bereich von Weichferriten ergibt sich darüber hinaus der Vorteil, dass der neue Werkstoff nicht toxisch ist und daher unbedenklich eingesetzt werden kann. Auch bei der Entsorgung entstehen keine umweltbedingten Probleme.

Durch die Verarbeitbarkeit des erfindungsgemäßen weichmagnetischen Werkstoffs mittels einer Sprühgranulierung, Trockenpressen und eines thermischen Aushärtens, z.B. einem Anlassen bzw. "Anschmelzen", ist eine schnelle, effektive und kostengünstige Herstellung verschiedenster Gegenstände möglich, was gegenüber dem bisher meist eingesetzten Spritzgussverfahren für Kompositwerkstoffe beachtliche Kostenvorteile hat.

Der relative Verlustfaktor tan d/$\mu_i$ gemessen bei 10MHz, 0,25 mT und 20°C ist kleiner 3000 x 10$^{-6}$, bevorzugt kleiner 1700 x 10$^{-6}$, noch besser kleiner 400 x 10$^{-6}$. Das Koerzitivfeld ist beachtlich hoch, wobei Werte für Hc im Bereich von 1200 A/m erreicht werden können.

Durch das Mischen von Mikro-Fraktion und Nano-Fraktion lassen sich große Volumenfüllfaktoren erreichen. Bei den Aufnahmeformen mit Binder sind Werte von etwa 80% und mehr möglich. Klassische Kompositwerkstoffe haben Volumenfüllfaktoren im Bereich von 50 bis höchstens 60%. Insgesamt ergibt sich ein weichmagnetischer Werkstoff mit hervorragenden Eigenschaften und vielseitiger Einsetzbarkeit, die zudem gezielt durch das Herstellungsverfahren steuerbar und auf gewünschte Werte einstellbar sind.

Im Folgenden werden vier erfindungsgemäße Beispiele detailliert beschrieben.

Beispiel 1

Zunächst wird die magnetische Komponente ausgewählt. Für dieses Beispiel werden gesinterte Kerne vorgelegt, die die für Leistungsferrite typischen Qualitätsansprüche erfüllen. Die Ausgangspermeabilität $\mu_i$ liegt zwischen 1800 und 3000, gemessen bei einer Flussdichte von B = 0,25 mT und bei einer Frequenz f von 10 kHz. Die Flussdichte $B_{250}$ betrug 330 bis 380 mT, gemessen bei einer Feldstärke H = 250 A/m und bei einer Frequenz von f = 16 kHz, sowie bei einer Temperatur von 100°C.

In Beispiel 1 wird ein Mangan-Zink-Ferrit verwendet, mit der Formel $Mn_aZn_bFe_{2+c}O_{4+d}$. Bei dem gewählten Beispiel ist a = 0,71, b = 0,18, c = 0,11 und d = -0,05.

Die Kerne werden durch einen Backenbrecher gebrochen und über geeignete Aggregate gemahlen. Anschließend wird das Mahlprodukt klassiert, z.B gesiebt, um die Teilchenfraktion von 40 $\mu$m und 70 $\mu$m für die magnetische Komponente zu erhalten.

Die beim Klassieren abgetrennte Fraktion mit einer Größe kleiner 40 $\mu$m wird anschließend einem zweistufigen Nassmahlprozess in Wasser unterzogen. Bei dem erfindungsgemäßen Beispiel werden Steelschot-Kugeln mit folgenden Größenverteilungen eingesetzt:

1. Mahlgang: 100 % < 0,850 mm, 90 % < 0,710 mm, 15 % < 0,425 mm, 3 % < 0,355 mm.
2. Mahlgang: 100 % < 0,425 mm, 90 % < 0,355 mm, 20 % < 0,180 mm, 10 % < 0,125 mm.

Der Feststoffgehalt bei diesem Nassmahlvorgang wird auf 40 Masse-% eingestellt.

Mittels Elektronenmikroskop ergibt sich eine mittlere Teilchengröße nach dem Nassmahlen im Bereich zwischen 50 und 100 nm. Die mittels BET-Oberfläche ermittelte Teilchengröße lag bei 42 nm.

In Beispiel 1 wird als Bindermaterial pulverförmiges Polyetheretherketon (PEEK) verwendet.

Bei dem Ausführungsbeispiel hat das pulverförmige PEEK eine Größenverteilung von 100 % < 50 $\mu$m; 50 % < 18 $\mu$m und 10 % < 4 $\mu$m.

In der Mischung aus Mikro-Fraktion, Nano-Fraktion und PEEK wird ein Sprühhilfsmittel in Form eines Polyvinylalkohols (PVA) zuzugeben. Dieser Polyvinylalkohol wird mittels Wasserdampf in Wasser gelöst, so dass sich eine 12 Masse-%ige wässrige PVA-Suspension ohne Segregationseffekt bildet.

Alle Komponenten zusammen wurden mit Wasser durch schnelles Rühren in Suspension gebracht. Die Suspension enthielt ca. 63,2 Masse-% der magnetischen Komponente, der Mikro-Fraktion, 27,1 Masse-% der Nano-Fraktion, 9 Masse-% des PEEK und 0,7 Masse-% PVA (bezogen auf die PVA-Trockenmasse) in einer adäquaten Wassermenge. Insgesamt betrug der Feststoffgehalt 56,5 Masse-%.

Die so gebildete Suspension oder Schlicker wird einer Sprühgranulierung zugeführt.

Bei dem erfindungsgemäßen Beispiel wird ein Sprühdruck von 12 bar eingestellt, der Düsen-Durchmesser lag bei 0,9 mm. Die Größe des Drallkörpers war 1 mm und die Temperatur wurde auf 140 bis 160°C eingestellt.

Das so gefertigte Sprühgranulat hatte eine Schüttdichte von 1,24 g/cm. Die Auslaufzeit betrug 47 Sekunden. Die Restfeuchte betrug 0,1 Masse-%.

Das Sprühgranulat wurde einer Siebanalyse unterzogen, wobei sich folgende Größenverteilung ergab: 0 % > 315 $\mu$m; 1 % > 250 $\mu$m; 23 % > 200 $\mu$m; 72 % > 125 $\mu$m, 95 % > 71 $\mu$m; 98 % > 45 $\mu$m. 2 % waren Staub.

Das so erhaltene Sprühgranulat eignet sich hervorragend zum Trockenpressen. Hierzu wurde das Sprühgranulat mit 0,5 Masse-% Wasser und 1 Masse-% Oxidharz gewälzt und uniaxial mit 350 MPa zu einem Ringkern verpresst.

In einem letzten Schritt wurde der so erhaltene Kern angelassen, d.h. er wurde mit 100 Kelvin/Minute auf 380°C erhitzt, dort für 4 Minuten belassen und mit einer Rate von 100 Kelvin/Minute wieder abgekühlt wobei der gesamte thermische Prozess bei einem Sauerstoffpartialdruck von $P_{02}$ = 20% (Luft) erfolgt.

Die Abmessungen des Ringkerns betrugen 29 mm Außendurchmesser, 21 mm Innendurchmesser und 8 mm Höhe. Der Ringkern wurden mit 5 Windungen bewickelt, um die Anfangspermeabilität $\mu_i$ und weitere magnetische Kenngrößen, wie tan d/$\mu$i zu messen. Die Messungen wurden mit 10 MHz, einer Flussdichte B = 0,25 mT und bei 20°C durchgeführt. Der Wert der Anfangspermeabilität $\mu_i$ ergab 22. Der Wert für tan d/$\mu$i war kleiner als $3000 \times 10^{-6}$.

Auch hinsichtlich seiner mechanischen Eigenschaften war das so hergestellte Material ausgezeichnet. Die Zugfestigkeit lag bei 9 N/mm$^2$, Die Dichte des Materials lag bei über 2,9 g/cm$^3$.

Beispiel 2

Das zweite Beispiel entsprach in der Herstellung und Zusammensetzung dem ersten Beispiel, mit der Ausnahme, dass der Pressdruck beim Trockenpressen bei 700 MPa lag.

Bei Beispiel 2 stellte sich ein Wert für die Anfangspermeabilität $\mu_i$ von 25 ein. Der Wert für tan d/$\mu$i war kleiner als $1700 \times 10^{-6}$.

Der erhöhte Pressdruck wirkte sich in einer Steigerung der Zugfestigkeit auf 14 N/mm$^2$ und einer Erhöhung der Dichte auf 3,1 g/cm$^3$ aus.

Beispiel 3

Beispiel 3 unterscheidet sich von Beispiel 2 dadurch, dass anstelle des PEEK-Kunststoffs ein Polyethylentetrafluorid (PTFE) eingesetzt wurde.

Zur Herstellung der Suspension wurde eine Größenverteilung von 100 % < 40 $\mu$m; 50 % < 5 $\mu$m und 10 % < 0,7 $\mu$m vorgelegt.

Der Pressdruck wurde wieder auf 700 MPa eingestellt.

Bei dem Beispiel 3 wurde das Anlassverfahren leicht modifiziert, wobei die Aufheizrate bei 10 Kelvin/Minute lag, und eine Endtemperatur von 360°C erzielt wurde. Der Kern wurde über 10 Minuten bei dieser Temperatur belassen und dann wieder mit einer Rate von 10 Kelvin/Minute abgekühlt.

Der so hergestellte Ringkern hatte eine Anfangspermeabilität $\mu_i$ von 33, und der Wert von tan d/$\mu$i lag bei weniger als 3000 x 10$^{-6}$. Mit diesem Kunststoff lässt sich eine Dichte von 4,1 g/cm$^3$ und eine Zugfestigkeit von 9 N/mm$^2$ erreichen.

Beispiel 4

Beispiel 4 unterscheidet sich von Beispiel 2 dadurch, dass bei der Mischung der Komponenten kein Kunststoffbinder verwendet wird und ferner die Stufe des thermischen Aushärtens unter veränderten Bedingungen durchgeführt wird

Bei dieser Ausführungsform wird beim thermischen Aushärten der erhaltene Kern mit 5 K/Minute bei einem Sauerstoffpartialdruck von $p_{O2}$ = 0,001 Volumen-% auf 1020 °C erhitzt, dann 2 Stunde bei $p_{O2}$ = 0,2 Volumen-% belassen und mit einer Rate von 5 K/Minute wieder abgekühlt. Beim Abkühlen erfolgt ein gradueller Abfall des Sauerstoffpartialdrucks bis auf einen Wert von $p_{O2}$ = 0,0001 Volumen-%, der bei 700 °C erreicht ist und bis zum vollständigen Abkühlen auf Raumtemperatur konstant anliegt. Die Wertepaare aus Temperatur T und Sauerstoffpartialdruck $p_{O2}$ stehen während der Abkühlphase in folgendem logarithmischen Zusammenhang: lg ($p_{O2}$) = 6,7 - (12240/T[K]).

Fig. 7 zeigt eine Elektronen-Mikroskopaufnahme eines Schliffs dieser Werkstoff. Hierbei sind beim thermischen Aushärten entstehende Sinterhälse zwischen den Teilchen des Nano-Fraktion und den Teilchen der Mikro-Fraktion erkennbar. Der so hergestellte Ringkern hatte eine Anfangspermeabilität $\mu_i$ von 120 und der Wert von tan d/$\mu_i$ lag bei weniger als 400 x 10$^{-6}$. Es wurde eine Dichte von 4,0 g/cm$^3$ und eine Zugfestigkeit von 14 N/mm$^2$ erreicht. Tabelle 1 fasst die Ergebnisse der Beispiele 1, 2, 3 und 4 noch einmal zusammen.

Tabelle 1

| Beispiel | Pressdruck [MPa] | Zugfestigkeit [N/mm$^2$] | Dichte [g/cm$^3$] | $\mu_i$ | tan d/$\mu_i$ [x 10$^{-6}$] |
|---|---|---|---|---|---|
| 1 | 350 | 9 | 2,9 | 22 | <3000 |
| 2 | 700 | 14 | 3,1 | 25 | <1700 |
| 3 | 700 | 9 | 4,1 | 33 | <3000 |
| 4 | 700 | 14 | 4,0 | 120 | <400 |

Die Anfangspermeabilität $\mu_i$ lässt sich beispielsweise durch das Verhältnis zwischen Mikro-Fraktion und Nano-Fraktion einstellen. Die Nano-Fraktion sollte zwischen 5 Masse-% und 70 Masse-% bezogen auf die Gesamtmasse der Mikro-Fraktion und der Nano-Fraktion gewählt werden. Auch die Größenverteilung der Mikro-Fraktion beeinflusst den Wert der Anfangspermeabilität $\mu_i$ beachtlich. Tendenziell gilt, dass sich bei kleineren Durchmessern der Mikro-Fraktion kleinere Werte für die Anfangspermeabilität $\mu_i$ einstellen lassen.

Mit der Erfindung ist es somit möglich, Werte der Anfangspermeabilität $\mu_i$ zwischen 5 und 200 vorzugeben.

Die mechanische Zugfestigkeit kann außer durch die Wahl des Pressdrucks beim Trockenpressschritt auch durch die Auswahl des Kunststoffbinders und das Mengenverhältnis zwischen Mikro-Fraktion und Nano-Fraktion beeinflusst werden.

Die für die magnetischen Verluste charakteristische Größe tan d/$\mu$i lag bei allen erfindungsgemäß hergestellten Werkstoffen deutlich unter 3000 x 10$^{-6}$, zum Teil deutlich unter 1500 x 10$^{-6}$ und sogar unter 400 x 10$^{-6}$. Die Messungen wurden bei 20°C und 10 MHz durchgeführt.

Zu den wesentlichen Vorteilen des erfindungsgemäßen weichmagnetischen Werkstoffs gehört es, dass er im Gegensatz zu anderen bekannten Kompositwerkstoffen mit weichmagnetischem Ferritteilchen nicht in einem aufwendigen und teuren Spritzgussverfahren verarbeitet werden muss, sondern in dem wesentlich kostengünstigeren und einfacheren Sprühtrocknungsverfahren mit anschließendem Trockenpressen. Dies senkt beachtlich die Herstellungskosten.

Die Erfindung ist nicht auf den Einsatz von Mangan-Zink-Ferrit als magnetische Komponente beschränkt. Auch andere Ferrite, wie etwa Nickel-Zink-Ferrit können verwendet werden.

Die Erfindung ist darüber hinaus auch nicht darauf beschränkt, nur eine Mikro-Fraktion und eine Nano-Fraktion einzusetzen. In vorteilhafter Weise ist es auch möglich, zwei diskrete Mikro-Fraktionen zu wählen, beispielsweise eine mit einem Teilchendurchmesser im Bereich von 60 bis 70 $\mu$m und eine zweite in einem Teilchenbereich von 30 bis 40 $\mu$m. Ähnliches gilt für die Nano-Fraktion.

Erfindungsgemäß wird jedoch durch die Kombination zumindest einer Mikro-Fraktion und einer Nano-Fraktion ein sehr wirksamer weichmagnetischer Werkstoff erhalten.

Auch hinsichtlich des eingesetzten Kunststoffmaterials für den optional Binder ist die Erfindung nicht auf PTFE und PEEK beschränkt. Auch andere Kunststoffe, wie beispielsweise Ethylen/Vinyl-Copolymerisate oder Polyamide können verwendet werden. Jedoch eignen sich diese Stoffe nur bedingt zur Sprühtrocknung und dem beschriebenen Härtungsverfahren, weshalb PEEK und PTFE bevorzugt sind.

Während bei den dargestellten Beispielen die Mikro-Fraktion und die Nano-Fraktion hinsichtlich der chemischen Zusammensetzung identisch waren, ist dies keineswegs zwingend vorgegeben. Die magnetischen und mechanischen Eigenschaften lassen sich auch beeinflussen, indem verschiedene Materialien für die Mikro-Fraktion und die Nano-Fraktion verwendet werden.

## Patentansprüche

1.   Weichmagnetischer Werkstoff, **dadurch gekennzeichnet, dass** der Werkstoff umfasst :

   eine Mikro-Fraktion aus Teilchen eines weichmagnetischen Materials mit einer Teilchengröße im Bereich von 1 bis 350 $\mu$m;
   eine Nano-Fraktion aus Teilchen eines weichmagnetischen Materials mit einer Teilchengröße im Bereich von 10 bis 200 nm,
   wobei der Anteil der Nano-Fraktion an der Gesamtmasse von Mikro-Fraktion und Nano-Fraktion 5 bis 70 Masse-% beträgt;
   und der Werkstoff mittels Sprühtrocknung hergestellt wird.

2.   Weichmagnetischer Werkstoff nach Anspruch 1, **dadurch gekennzeichnet, dass**
   das weichmagnetische Material ein Ferrit, insbesondere Mangan-Zink-Ferrit, ist und wobei die Teilchen der Mikro-Fraktion und der Nano-Fraktion optional aus dem gleichen Material bestehen.

3.   Weichmagnetischer Werkstoff nach Anspruch 2, **dadurch gekennzeichnet, dass**
   der Mangan-Zink-Ferrit der Formel $Mn_aZn_bFe_{2+c}O_{4+d}$ entspricht, wobei die Größe a, b, c und d in folgendem Bereich liegen:

$$0,05 < a < 0,8;$$

$$0,05 < b < 0,6;$$

$$0,02 < c < 0,9;$$

$$-0,05 < d < 0,05,$$

   wobei

$$a + b + c = 1 \text{ ist.}$$

4.   Weichmagnetischer Werkstoff nach einem der Ansprüche 1-3, **dadurch gekennzeichnet, dass**
   der Anteil der Nano-Fraktion an der Gesamtmasse von Mikro-Funktion und Nano-Fraktion mindestens 10 Masse-%, weiter bevorzugt mindestens 30 Masse-% beträgt und ferner weniger als 50 Masse-%, weiter bevorzugt weniger als 40 Masse-% der Nano-Fraktion beträgt.

5. Weichmagnetischer Werkstoff nach einem der Ansprüche 1-4, **dadurch gekennzeichnet, dass** die Dichte 2,9 g/cm$^3$ oder mehr, bevorzugt mehr als 3,1 g/cm$^3$ und insbesondere bevorzugt 4 g/cm$^3$ oder mehr beträgt, nachdem der Werkstoff einem Sprühtrocknungsschritt, einem Trockenpressschritt und einem Anlassschritt bzw. ein Anschmelzschritt unterzogen wurde.

6. Weichmagnetischer Werkstoff nach einem der Ansprüche 1 - 5, **dadurch gekennzeichnet, dass** die Zugfestigkeit mehr als 3 N/mm$^2$, bevorzugt mehr als 9 N/mm$^2$ und insbesondere bevorzugt mehr als 14 N/mm$^2$ beträgt, nachdem der Werkstoff einem Sprühtrocknungsschritt, einem Trockenpressschritt und einem Anlassschritt bzw. ein Anschmelzschritt unterzogen wurde.

7. Weichmagnetischer Werkstoff nach einem der Ansprüche 1-6, **dadurch gekennzeichnet, dass** die Anfangspermeabilität $\mu_i$ bei 5 bis 200, die Sättigungsmagnetisierung bei 100 mT oder mehr und der Wert für tan $\delta/\mu_i$ kleiner 3000 x 10$^{-6}$, bevorzugt kleiner 1700 x 10$^{-6}$, noch bevorzugter kleiner 400 x 10$^{-6}$ ist, nachdem der Werkstoff einem Sprühtrocknungsschritt, einem Trockenpressschritt und einem Anlassschritt bzw. Anschmelzschritt unterzogen wurde.

8. Weichmagnetischer Werkstoff nach einem der Ansprüche 1-7, **dadurch gekennzeichnet, dass** der Werkstoff ferner einen Kunststoffbinder umfasst.

9. Weichmagnetischer Werkstoff nach Anspruch 8, **dadurch gekennzeichnet, dass** der Kunststoffbinder Polyethylentetrafluorid (PZFE) oder ein Polyetheretherketon (PEEK) ist.

10. Weichmagnetischer Werkstoff nach Anspruch 9, **dadurch gekennzeichnet, dass** der Anteil des Binders, bezogen auf die Gesamtmasse von Mikro-Fraktion und Nano-Fraktion, im Bereich von 5 bis 20 Masse-%, bevorzugt bei 8 bis 12 Masse-% liegt.

11. Verfahren zur Herstellung eines Gegenstandes aus einem weichmagnetischen Kompositwerkstoff gemäß Ansprüche 8-10, umfassend :

Bereitstellen eines Schlickers mit einem teilchenförmigen weichmagnetischen Material, einem teilchenförmigen Kunststoffbinder, einem Sprühhilfsmittel und einem Schlickermedium;
Sprühtrocknen des Schlickers;
Trockenpressen des durch die Sprühtrocknung erhaltenen Granulates zusammen mit einem Presshilfsmittel;
Anschmelzen des Kunststoffbinders durch Erwärmen des gepressten Gegenstands auf eine Temperatur oberhalb des Schmelzpunktes des Kunststoffbinders.

12. Verfahren nach Anspruch 11, wobei das Schlickermedium Wasser ist.

13. Verfahren nach Anspruch 11, wobei das Sprühtrocknen bei einer Temperatur von 140°C bis 160°C und einem Druck von 5 bis 20 bar ausgeführt wird.

14. Verfahren nach Anspruch 11, wobei das Trockenpressen bei 350 MPa bis 700 MPa ausgeführt wird.

15. Verfahren nach Anspruch 11, wobei bei dem das Erwärmen gemäß einem vorbestimmten Temperaturprofil erfolgt, mit einer erste Aufheizphase mit einer Rate von 10 bis 100 K/Minute, einer Haltephase von 3 bis 10 Minuten und einer Abkühlphase mit einer Rate von 10 bis 100 K/Minute.

16. Verfahren zur Herstellung eines Gegenstandes aus einem weichmagnetischen Werkstoff gemäß Ansprüche 1-7, umfassend:

Bereitstellen eines Schlickers mit einem teilchenförmigen weichmagnetischen Material, einem Sprühhilfsmittel und einem Schlickermedium;

Sprühtrocknen des Schlickers;
Trockenpressen des durch die Sprühtrocknung erhaltenen Granulates zusammen mit einem Presshilfsmittel;
Anlösen der weichmagnetischen Teilchen durch Erwärmen des gepressten Gegenstands unter verminderten Sauerstoffpartialdruck auf eine Temperatur, bei der die weichmagnetischen Teilchen über "Sinterhälse" verfestigt werden.

17. Verfahren zur Herstellung eines Gegenstandes aus einem weichmagnetischen Werkstoff nach Anspruch 16, wobei das Erwärmen des gepressten Gegenstands die Schritte umfasst:

Erhitzen mit 5 K/Minute bei einem Sauerstoffpartialdruck von $p_{O2}$ = 0,001 Volumen-% auf 1020 °C,
Belassen über 2 Stunde bei $p_{O2}$ = 0,2 Volumen-%, und
Abkühlen mit einer Rate von 5 K/Minute, wobei beim Abkühlen ein gradueller Abfall des Sauerstoffpartialdrucks bis auf einen Wert von $p_{O2}$ = 0,0001 Volumen-% erfolgt, der bei 700 °C erreicht ist und bis zum vollständigen Abkühlen auf Raumtemperatur konstant anliegt, und wobei Wertepaare aus Temperatur T und Sauerstoffpartialdruck $p_{O2}$ während der Abkühlphase in folgendem logarithmischen Zusammenhang stehen:

$$\lg\ (p_{O2})\ =\ 6,7\ -\ (12240/T[K]).$$

Claims

1. Soft magnetic material, **characterised in that** the material comprises:

a microfraction made up of particles of a soft magnetic material having a particle size in the range of from 1 to 350 $\mu$m;
a nanofraction made up of particles of a soft magnetic material having a particle size in the range of from 10 to 200 nm;
the proportion of the nanofraction based on the total mass of microfraction and nanofraction being from 5 to 70 % by mass;
and the material being produced by means of spray drying.

2. Soft magnetic material according to claim 1, **characterised in that** the soft magnetic material is a ferrite, in particular manganese-zinc ferrite, and the particles of the microfraction and of the nanofraction optionally consisting of the same material.

3. Soft magnetic material according to claim 2, **characterised in that** the manganese-zinc ferrite corresponds to the formula $Mn_aZn_bFe_{2+c}O_{4+d}$, the size of a, b, c and d being in the following ranges:

$$0.05 < a < 0.8;$$

$$0.05 < b < 0.6;$$

$$0.02 < c < 0.9;$$

$$-0.05 < d < 0.05,$$

where

$$a + b + c = 1.$$

4. Soft magnetic material according to any of claims 1 to 3, **characterised in that** the proportion of the nanofraction based on the total mass of microfraction and nanofraction is at least 10 % by mass, more preferably at least 30 % by mass, and also less than 50 % by mass, more preferably less than 40 % by mass of the nanofraction.

5. Soft magnetic material according to any of claims 1 to 4, **characterised in that** the density is 2.9 g/cm$^3$ or more, preferably more than 3.1 g/cm$^3$ and particularly preferably 4 g/cm$^3$ or more, after the material has been subjected to a spray drying step, a dry pressing step and a tempering step or a fusing step.

6. Soft magnetic material according to any of claims 1 to 5, **characterised in that** the tensile strength is more than 3 N/mm$^2$, preferably more than 9 N/mm$^2$ and particularly preferably more than 14 N/mm$^2$, after the material has been subjected to a spray drying step, a dry pressing step and a tempering step or a fusing step.

7. Soft magnetic material according to any of claims 1 to 6, **characterised in that** the initial permeability $\mu_i$ is from 5 to 200, the saturation magnetisation is 100 mT or more and the value of tan $\delta/\mu_i$ is less than 3000 x 10$^{-6}$, preferably less than 1700 x 10$^{-6}$, more preferably less than 400 x 10$^{-6}$, after the material has been subjected to a spray drying step, a dry pressing step and a tempering step or fusing step.

8. Soft magnetic material according to any of claims 1 to 7, **characterised in that** the material further comprises a plastics binder.

9. Soft magnetic material according to claim 8, **characterised in that** the plastics binder is polytetrafluoroethylene (PTFE) or a polyether ether ketone (PEEK).

10. Soft magnetic material according to claim 9, **characterised in that** the proportion of binder, based on the total mass of microfraction and nanofraction, is in the range of from 5 to 20 % by mass, preferably from 8 to 12 % by mass.

11. Method for producing an article from a soft magnetic composite material according to claims 8 to 10, comprising:

   providing a slip comprising a particulate soft magnetic material, a particulate plastics binder, a spraying auxiliary agent and a slip medium;
   spray drying the slip;
   dry pressing the granules obtained by spray drying together with a pressing auxiliary agent;
   fusing the plastics binder by heating the pressed article to a temperature above the melting point of the plastics binder.

12. Method according to claim 11, wherein the slip medium is water.

13. Method according to claim 11, wherein spray drying is carried out at a temperature of from 140 °C to 160 °C and a pressure of from 5 to 20 bar.

14. Method according to claim 11, wherein dry pressing is carried out at from 350 MPa to 700 MPa.

15. Method according to claim 11, wherein heating is carried out according to a predetermined temperature profile, comprising a first heating phase having a rate of from 10 to 100 K/minute, a hold phase of from 3 to 10 minutes and a cooling phase at a rate of from 10 to 100 K/minute.

16. Method for producing an article from a soft magnetic material according to claims 1-7, comprising:

   providing a slip comprising a particulate soft magnetic material, a spraying auxiliary agent and a slip medium;
   spray drying the slip;
   dry pressing the granules obtained by spray drying together with a pressing auxiliary agent;
   softening up the soft magnetic particles by heating the pressed article under a reduced oxygen partial pressure to a temperature at which the soft magnetic particles are hardened by means of "sinter necks".

17. Method for producing an article from a soft magnetic material according to claim 16, wherein the heating of the pressed article comprises the steps of:

   heating at 5 K/minute at an oxygen partial pressure of $p_{o2}$ = 0.001 % by volume to 1020 °C,
   leaving for 2 hours at $p_{o2}$ = 0.2 % by volume, and

cooling at a rate of 5 K/minute, wherein the oxygen partial pressure is gradually decreased during cooling to a value of $p_{o2}$=0.0001 % by volume, which pressure is reached at 700° C and is kept constant until complete cooling to room temperature has occurred, and wherein value pairs of temperature T and oxygen partial pressure $p_{o2}$ have the following logarithmic relationship during the cooling phase:

$$lg\ (p_{o2}) = 6.7 - (12{,}240/T[K]).$$

**Revendications**

1. Matériau magnétique doux, **caractérisé en ce que** le matériau comprend :

   une microfraction de particules d'une matière magnétique douce d'une taille particulaire dans la plage de 1 à 350 $\mu$m ;
   une nanofraction de particules d'une matière magnétique douce d'une taille particulaire dans la plage de 10 à 200 nm,
   dans lequel la proportion de la nanofraction par rapport à la masse totale de microfraction et de nanofraction est de 5 à 70 % en masse ;
   et le matériau est fabriqué par séchage par pulvérisation.

2. Matériau magnétique doux selon la revendication 1, **caractérisé en ce que**
   la matière magnétique douce est une ferrite, en particulier une ferrite de manganèse et de zinc, et dans lequel les particules de la microfraction et de la nanofraction sont constituées éventuellement de la même matière.

3. Matériau magnétique doux selon la revendication 2, **caractérisé en ce que**
   la ferrite de manganèse et de zinc correspond à la formule $Mn_aZn_bFe_{2+c}O_{4+d}$, dans laquelle les grandeurs a, b, c et d se situent dans les plages suivantes :

$$0{,}05 < a < 0{,}8 \ ;$$

$$0{,}05 < b < 0{,}6 \ ;$$

$$0{,}02 < c < 0{,}9 \ ;$$

$$-0{,}05 < d < 0{,}05,$$

dans laquelle

$$a + b + c = 1.$$

4. Matériau magnétique doux selon l'une quelconque des revendications 1 à 3, **caractérisé en ce que**
   la proportion de la nanofraction par rapport à la masse totale de microfraction et de nanofraction atteint au moins 10 % en masse, de préférence au moins 30 % en masse, et atteint en outre moins de 50 % en masse, de préférence moins de 40 % en masse de la nanofraction.

5. Matériau magnétique doux selon l'une quelconque des revendications 1 à 4, **caractérisé en ce que**
   la masse volumique atteint 2,9 g/cm$^3$ ou plus, de préférence plus de 3,1 g/cm$^3$ et de manière particulièrement préférée 4 g/cm$^3$ ou plus, après que le matériau a été soumis à une étape de séchage par pulvérisation, à une étape de compression à sec et à une étape de revenu ou à une étape de fusion.

**6.** Matériau magnétique doux selon l'une quelconque des revendications 1 à 5, **caractérisé en ce que** la résistance à la traction atteint plus de 3 N/mm$^2$, de préférence plus de 9 N/mm$^2$ et de manière particulièrement préférée plus de 14 N/mm$^2$, après que le matériau a été soumis à une étape de séchage par pulvérisation, à une étape de compression à sec et à une étape de revenu ou à une étape de fusion.

**7.** Matériau magnétique doux selon l'une quelconque des revendications 1 à 6, **caractérisé en ce que** la perméabilité de départ $\mu_i$ est de 5 à 200, la magnétisation de saturation de 100 mT ou plus et la valeur pour tg $\delta/\mu_i$ inférieure à 3000 x 10$^{-6}$, de préférence inférieure à 1700 x 10$^{-6}$, mieux encore inférieure à 400 x 10$^{-6}$, après que le matériau a été soumis à une étape de séchage par pulvérisation, à une étape de compression à sec et à une étape de revenu ou à une étape de fusion.

**8.** Matériau magnétique doux selon l'une quelconque des revendications 1 à 7, **caractérisé en ce que** le matériau comprend en outre un liant synthétique.

**9.** Matériau magnétique doux selon la revendication 8, **caractérisé en ce que** le liant synthétique est un poly(tétrafluorure d'éthylène) (PZFE) ou une polyétheréthercétone (PEEK).

**10.** Matériau magnétique doux selon la revendication 9, **caractérisé en ce que** la proportion du liant par rapport à la masse totale de microfraction et de nanofraction se situe dans la zone de 5 à 20 % en masse, de préférence de 8 à 12 % en masse.

**11.** Procédé de fabrication d'un objet à partir d'un matériau composite magnétique doux selon les revendications 8 à 10, comprenant :

la préparation d'une suspension avec une matière magnétique douce particulaire, un liant synthétique particulaire, un agent auxiliaire de pulvérisation et un milieu de suspension ;
le séchage par pulvérisation de la suspension ;
la compression à sec du granulé obtenu par séchage par pulvérisation conjointement avec un agent auxiliaire de compression ;
la fusion du liant synthétique par chauffage de l'objet comprimé à une température supérieure au point de fusion du liant synthétique.

**12.** Procédé selon la revendication 11, dans lequel le milieu de suspension est l'eau.

**13.** Procédé selon la revendication 11, dans lequel le séchage par pulvérisation est réalisé à une température de 140 °C à 160 °C et à une pression de 5 à 20 bars.

**14.** Procédé selon la revendication 11, dans lequel la compression à sec est réalisée à une pression de 350 MPa à 700 MPa.

**15.** Procédé selon la revendication 11, dans lequel le chauffage se fait selon un profil de températures prédéterminé avec une première phase de chauffage à raison d'une vitesse de 10 à 100 K/minute, une phase de maintien de 3 à 10 minutes et une phase de refroidissement à raison d'une vitesse de 10 à 100 K/minute.

**16.** Procédé de fabrication d'un objet à partir d'un matériau magnétique doux selon les revendications 1 à 7, comprenant :

la préparation d'une suspension avec une matière magnétique douce particulaire, un agent auxiliaire de pulvérisation et un milieu de suspension ;
le séchage par pulvérisation de la suspension ;
la compression à sec du granulé obtenu par le séchage par pulvérisation conjointement avec un agent auxiliaire de compression ;
la dissolution des particules de matériau magnétique doux par chauffage de l'objet comprimé à une pression partielle d'oxygène réduite et à une température dans laquelle les particules de matériau magnétique doux sont consolidées via « des colles de frittage ».

**17.** Procédé de fabrication d'un objet à partir d'un matériau magnétique doux selon la revendication 16, dans lequel le chauffage de l'objet comprimé comprend les étapes suivantes :

chauffage à raison de 5 K/minute à une pression partielle d'oxygène de $p_{0,2}$ = 0,001 % en volume à 1020 °C, repos de deux heures à $p_{0,2}$ = 0,2 % en volume et

refroidissement à raison de 5 K/minute, dans lequel, lors du refroidissement, il se produit une chute graduelle de la pression partielle d'oxygène jusqu'à une valeur de $p_{0,2}$ = 0,0001 % en volume, qui est atteinte à 700 °C et qui s'applique de manière constante jusqu'au refroidissement total à température constante, et dans lequel des paires de valeurs formées de la température T et de la pression partielle d'oxygène $p_{0,2}$ répondent au cours de la phase de refroidissement à l'expression logarithmique suivante :

$$\lg(p_{0,2}) = 6,7 - (12240/T[K]).$$

FIGUR 1

FIGUR 2

```
                    ┌─────────────────┐
                    │   Auswahl der   │
                    │  Komponenten    │
                    └─────────────────┘

┌──────────────┐ ┌──────────────┐ ┌──────────┐ ┌──────────────────┐ ┌──────────────┐
│ magnetische  │ │ nanoskalige  │ │  Binder  │ │ Sprühhilfsmittel │ │  Schlicker-  │
│ Komponente   │ │Füllkomponente│ │(optional)│ │                  │ │   medium     │
└──────────────┘ └──────────────┘ └──────────┘ └──────────────────┘ └──────────────┘

                    ┌─────────────────┐
                    │     Mischen     │
                    └─────────────────┘

                    ┌─────────────────┐
                    │     Sprüh-      │
                    │  granulierung   │
                    └─────────────────┘

                    ┌─────────────────┐
                    │    Trocken-     │
                    │    pressen      │
                    └─────────────────┘

                    ┌─────────────────┐
                    │   Thermisches   │
                    │   Aushärten     │
                    └─────────────────┘
```

# FIGUR 3

TWK 190005/2, 1.DL+75 min., x5000 ⊢———— 5 µm ————⊣

FIGUR 4

Pr. N2, x5000                                              ⊢——— 5 µm ———⊣

FIGUR 5

Pr. M11R, x5000      ⊢——— 5 µm ———⊣

FIGUR 6

SE Schliff TS 152       ⊢——— 30 µm ———⊣

FIGUR 7

**EP 2 131 373 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10222459 A1
- EP 1564767 A2
- EP 1669408 A
- EP 1790460 A1
- DE 10790460 A1
- US 20070102663 A1

- US 20020190236 A1
- EP 1818954 A1
- WO 2006122195 A
- JP 2005145803 A
- EP 921534 A

**In der Beschreibung aufgeführte Nicht-Patentliteratur**

- Ferrites and Accessoires. EPCOS AG, September 2006
- Inductive Component and Modules. Vogt Elektronic Components GmbH, 2005

- Keratherm Typ 86/XX. *Sicherheitsdatenblatt,* Juni 2000